(19) **Europäisches Patentamt / European Patent Office / Office européen des brevets**

(11) **EP 1 097 386 B1**

(12) **EUROPEAN PATENT SPECIFICATION**

(45) Date of publication and mention
of the grant of the patent:
**21.02.2007 Bulletin 2007/08**

(51) Int Cl.:
*G01R 27/26* (2006.01)    *G01R 27/28* (2006.01)
*H03B 1/00* (2006.01)    *H03K 19/00* (2006.01)
*H03K 19/003* (2006.01)

(21) Application number: **99930293.8**

(22) Date of filing: **15.06.1999**

(86) International application number:
**PCT/US1999/013528**

(87) International publication number:
**WO 1999/066336 (23.12.1999 Gazette 1999/51)**

(54) **ADAPTIVE DRIVER WITH CAPACITIVE LOAD SENSING AND METHOD OF OPERATION**

ADAPTIVER TREIBER MIT KAPAZITIVER LASTFÜHLUNG UND BETRIEBSVERFAHREN DAZU

PILOTE ADAPTABLE A DETECTION DE CHARGES CAPACITIVES ET SON MODE DE FONCTIONNEMENT

(84) Designated Contracting States:
**DE GB**

(30) Priority: **15.06.1998 US 97605**
**15.06.1998 US 97886**

(43) Date of publication of application:
**09.05.2001 Bulletin 2001/19**

(73) Proprietor: **International Microcircuits, Inc.
Milpitas, CA 95035 (US)**

(72) Inventor: **OZGUC, Ismail, H.
Sunnyvale, CA 94087 (US)**

(74) Representative: **Strachan, Victoria Jane et al
Urquhart-Dykes & Lord LLP
Churchill House
Churchill Way
Cardiff CF10 2HH (GB)**

(56) References cited:
**US-A- 4 829 199       US-A- 4 873 673
US-A- 5 260 901       US-A- 5 677 639
US-A- 5 877 634       US-A- 5 886 554**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

Printed by Jouve, 75001 PARIS (FR)

**Description**

Cross-Reference to Related Applications

This application is related to US Patent Numbers 6037811 and 6130541.

Background of the Invention

The present invention relates in general to integrated circuits, and in particular to an adaptive driver circuit capable of sensing the amount of capacitive load at its output and adjusts its output drive level to produce a desired output signal slew rate.

In certain applications, an electronic system may require an integrated circuit (IC) to drive other circuitry that present variable capacitive load conditions. For example, in a computer system, a clock driver IC would have to drive varying capacitive loads depending on the size of the memory system implemented. When adding memory to a PCT, for example, the same IC must drive a larger capacitive load.

US Patent Number 5,677,639 describes an arrangement including a load recognition unit for determining the load impedance, which is then used to control a programmable output buffer to source/sink an amount of output current appropriate to the load to be driven. US Patent Number 5,260,901 describes an output circuit for providing data read from a storage element, such as a dynamic random access memory, to an output terminal. The number of switching elements in the output circuit that are rendered conductive is dependent on the magnitude of the load and the rise time and fall time of the output waveform can be maintained constant so as to suppress ringing. US Patent Number 4,829,199 describes a CMOS inverter driver circuit capable of adapting by feedback detection to varying capacitive load conditions. US Patent Number 5,886,554 describes a differential driver with slew rate control means in the form of a diode and also a capacitor located in the voltage to current converter that is scaled to motor a slew rate control capacitor in the integrator. The capacitor and diode delay the rising edge of the voltage input to a current mirror in the voltage to current converter. This delay matches the propagation delays, such that both slew control and skew control are achieved.

As is known in the art, the slew rate of the driver's output signal is dependent upon its output drive (current) supplied to the capacitive load and the value of the capacitive load, as shown in equation 1:

$$\text{Slew rate} = \Delta V_c / \Delta t = I/C \qquad (1)$$

where

$V_c$ = the capacitive load voltage
t = the rise/fall time
I = the current delivered to the capacitive load
C = the value of the capacitive load

Thus, it can be seen that for small load capacitances and/or large driver currents, the slew rate will be correspondingly higher than for large load capacitances and/or small supplied currents.

In order to accommodate variable capacitive loading conditions as described above, conventional driver circuits typically supply a fixed amount of current assuming the largest capacitive load. The fixed current is that which will drive the largest anticipated capacitive load and still meet the desired slew rate. However, in circumstances in which the capacitive load is smaller, the slew rate will be faster than desired.

A faster than desired slew rate is disadvantageous since the driver can generate a greater number of high frequency harmonics. High frequency harmonics can give rise to electromagnetic interference (EMI), which in some instances may exceed the maximum tolerable EMI specifications. Furthermore, the fixed output drive level will generate output signals having varying slew rates as different memory configurations having different load capacitances are installed. The varying clock slew requires slew rate adjustment circuitry which adds to circuit complexity and cost. Lastly, the conventional driver circuit does not possess the capability of providing slew rate adjustability. It is often desirable to alter the slew rate of the input drive signal to correct for effects caused by preceding circuitry.

What is needed is a driver circuit which is capable of varying its output drive level so that the output signal slew rate can be adjusted as desired.

## SUMMARY OF THE INVENTION

The present invention provides methods and circuitry for sensing the capacitive loading of a driver circuit and then adjusting the drive output accordingly to provide a desired slew rate. In one embodiment, the circuit of the present invention includes a capacitance sensor, a control circuit, and an output driver. The capacitance sensor measures the unknown load capacitance. The control circuit generates a control signal in response to the capacitive load measurement. The output driver receives the control signal and in response produces an output level which when supplied to the capacitive load produces an output signal having the desired slew rate.

The driver's output level can be controlled such that the output slew rate remains substantially the same over varying load capacitances. In this configuration, the new driver offers the advantage of providing a more uniform output slew rate, averting the need for slew rate correction circuitry. In addition, the new driver consumes less power than the conventional driver circuit since it generates and supplies only the minimal drive level needed to produce the desired slew rate. Alternatively, the output slew rate may also be adjusted (by controlling the output level) up or down to correct for any effects caused by the preceding circuitry.

A better understanding of the nature of the invention and advantages of the adaptive driver of the present invention may be gained by referring to the following detailed description and drawings below.

## BRIEF DESCRIPTION OF THE DRAWINGS

Figure 1 illustrates a simplified block diagram of the adaptive driver circuit in accordance with the present invention.
Figure 2 is a flow chart describing the method of operation of the adaptive driver circuit shown in Figure 1.
Figure 3 illustrates a first embodiment of the adaptive driver circuit shown in Figure 1.
Figures 4A-4D are timing diagrams showing the operation of the adaptive driver circuit of Figure 3.
Figure 5 illustrates a second embodiment of the adaptive driver circuit shown in Figure 1.
Figure 6 is a timing diagram illustrating the operation of the adaptive driver circuit of Figure 5.

## DESCRIPTION OF THE PREFERRED EMBODIMENT

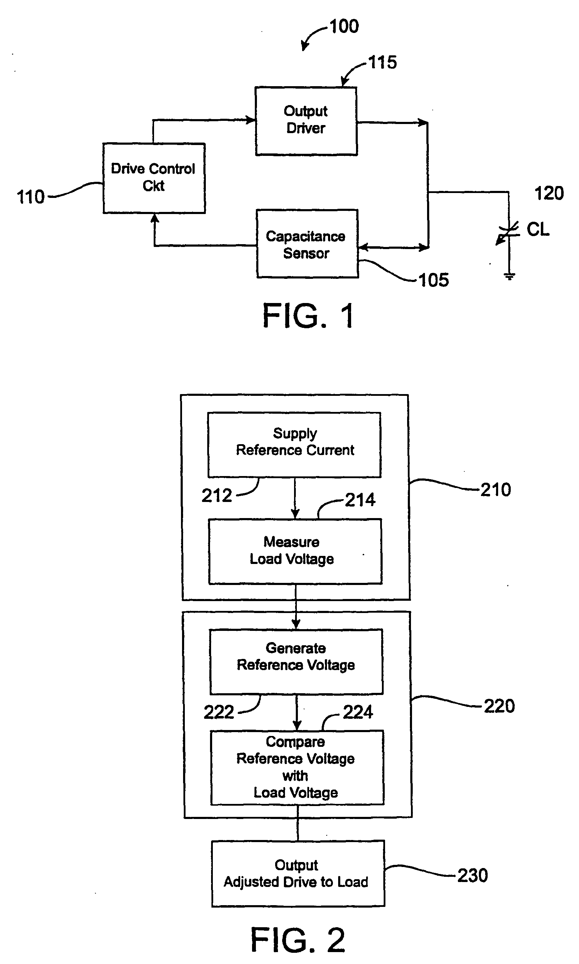

Figure 1 shows a simplified block diagram of an adaptive output driver in accordance with the present invention. The adaptive driver 100 includes a capacitance sensor 105, a control circuit 110, and a driver circuit 115. The capacitance sensor 105 and the output driver 115 are coupled to an unknown capacitive load 120.

Figure 2 shows a flow chart describing the adaptive output driver's 100 method of operation. Initially at step 210, the capacitance sensor measures the amount of capacitance $C_L$ 120 which is present at the load. In the preferred embodiment, this is accomplished by first supplying a reference current to the capacitive load for a predefined time period (step 212) and then measuring the voltage attributable to the supplied reference current at the end of the predefined period (step 214). Subsequently at step 220, a control signal is generated in response to the measured load capacitance. In the preferred embodiment, control signal generation is accomplished by generating a reference voltage level (step 222) and comparing the reference voltage level with the load voltage level attributable to the supplied reference current (step 224). Finally at step 230, the control signal is communicated to the driver circuit for increasing or decreasing the amount of current supplied to the capacitive load. In this manner, the driver circuit supplies an appropriate amount of current to the unknown capacitive load so that the slew rate of the output drive signal is produced as desired.

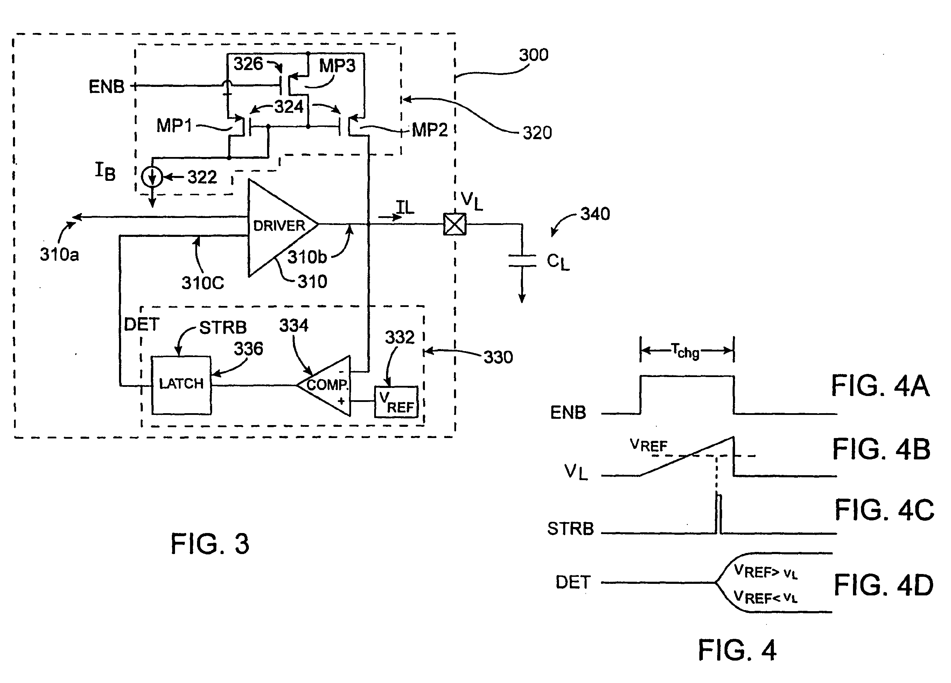

Figure 3 illustrates a detailed schematic of the adaptive output driver in a first embodiment. In this embodiment, the adaptive driver 300 includes a driver circuit 310, a charging circuit 320, and a control circuit 330. The driver circuit 310 includes an input terminal 310a for receiving the input signal, an output terminal 310b for transmitting a subsequently produced output signal, and a control terminal 310c for receiving a driver control signal, described below. The driver circuit 310 may be any variable output driver circuit.

The charging circuit 320 includes a current source 322, a current mirror 324, and an enabling circuit 326. In the preferred embodiment of Figure 3, the current mirror 324 consists of two FET transistors MP1 and MP2 and the enabling circuit 326 is a FET device MP3 coupled between $V_{CC}$ and the common gate terminal of the current mirror transistors MP1 and MP2. Alternatively, the current mirror and enabling circuitry may be devices of any transistor type and include multiple transistors of the same or varying gate peripheries.

During operation, the charging circuit 320 supplies a known load current $I_L$ to an unknown capacitive load 340. The load current $I_L$ is produced by mirroring the bias current $I_B$ using transistors MP1 and MP2. Transistor MP3 is turned off and $I_L$ is allowed to charge $C_L$ 340 up for a maximum fixed duration of time $T_{chg}$ as governed by an enable signal ENB, shown in Figure 4A. During the time period $T_{chg}$, a load voltage $V_L$ (Figure 4B) develops across the unknown capacitive load 340, increasing at a rate of $I_L$ divided by $C_L$. Thus, $V_L$ will increase slower for larger capacitive loads and faster for smaller capacitive loads.

The control circuit 330 monitors the load voltage $V_L$ developed across $C_L$ in response to the supply of $I_L$. In addition, a reference voltage $V_{ref}$ is produced by a reference generator 332. The reference voltage $V_{ref}$ and the load voltage $V_L$ are supplied to complementary inputs of a comparator 334. The comparator 334 compares the voltage levels of $V_L$ and $V_{ref}$, and in response generates a high (low) signal when the non-inverting (or inverting) input is larger in magnitude. In Figure 3, $V_L$ is sampled at the inverting input. Thus, when $V_L$ surpasses $V_{ref}$ as shown in Figure 4B, the comparator 334 outputs a low signal.

The comparator's output signal is received by a latch circuit 336. A strobe signal STRB (Figure 4C) activates the latch circuit 336 to sample the comparator's output signal and transmit it to the control terminal 310c of the driver circuit 310. The latch circuit 336 outputs the DET control signal when strobed, as shown in Figure 4D. The DET control signal is subsequently fed into the control terminal 310c of the driver circuit 310 to vary the output of the driver 310 higher (or lower) if the detected capacitive load 340 is larger (or smaller) than the threshold load capacitance.

The STRB signal can be timed to activate the latch circuit 336 at an earlier or later point during the $T_{Chg}$ period, resulting in a shorter or longer charging period, and accordingly a lower or higher $V_L$ value. In addition, the magnitude of reference current $I_L$ supplied and the maximum time period over which the unknown load capacitance is allowed to charge ($T_{chg}$) may be varied up or down to accommodate larger or smaller anticipated capacitive loads $C_L$ 340.

In the above embodiment, while the charging duration can be made accurate by generating a STRB signal using, for example, a crystal oscillator, the amount of current $I_L$ may not be as accurate. The load current $I_L$ depends on the bias current $I_B$ whose value is typically dependent on power supply, temperature and process variations. In a typical CMOS process, the variation in the magnitude of $I_B$ and thus variations in the final detected value for $C_L$ may be as high as +/- 20% to 25%. The accuracy of this circuit can be improved somewhat by well-known trimming techniques.

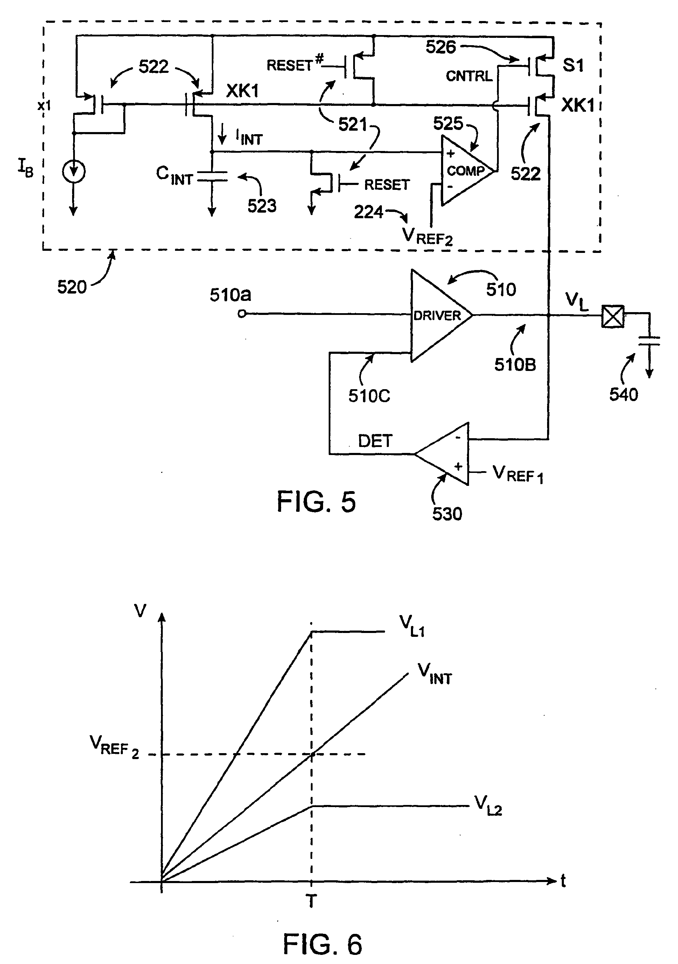

Figure 5 illustrates an alternative embodiment of the present invention where, instead of making the charging duration a fixed period, the charging duration is made proportional to the bias current $I_B$. In this embodiment, the charging circuit 520 replicates its corresponding functions described in the first embodiment. The charging circuit 520 includes reset circuitry 521, a current mirror 522, an internal capacitor 523, a reference generator 524, a voltage comparator 525 and a switch transistor 526.

When the RESET transistors are released, $I_B$ is mirrored as $I_{INT}$ charging internal capacitor $C_{INT}$ 523. The current $I_B$ is also mirrored as $I_L$ to charge the unknown capacitive load $C_L$ 540. The mirroring ratios can be adjusted such that $I_{INT} = I_L = k1 * I_B$. The internal capacitor $C_{INT}$ 523 may be realized as a lumped element capacitor or as transistor parasitic capacitance.

As the internal capacitor $C_{INT}$ 523 integrates the current $I_{INT}$, the voltage $V_{INT}$ across $C_{INT}$ 521 rises linearly. Concurrently, a reference generator 524 produces a voltage $V_{ref2}$. Voltages $V_{ref2}$ and $V_{INT}$ are supplied to complementary inputs of a voltage comparator 525. When $V_{INT}$ reaches $V_{ref2}$, the comparator 525 outputs a low signal, which turns a switch transistor S1 off. This switches off the load current $I_L$, which stops the load voltage $V_L$ from increasing. The control signal CTRL which sets the charging duration for $C_L$ 540, is thus made to vary with the variation in the amount of bias current $I_B$. As a result, the capacitance detection circuit operates with much improved accuracy over process variations.

Figure 6 shows a graph of voltages $V_{ref2}$, $V_{INT}$, and $V_L$ versus time. The voltage $V_{ref2}$ remains constant over time, while $V_{INT}$ increases linearly depending upon the size of $C_{INT}$ and the magnitude of $I_{INT}$ ($I_B$). At time T, $V_{INT}$ reaches $V_{ref2}$ and the comparator produces a high output (since $V_{INT}$ is coupled to the non-inverting input), turning switch transistor S1 off, and terminating the charging period. Graph lines $V_{L1}$ and $V_{L2}$ illustrate two respective load voltages at the cutoff time T, $V_{L1}$ representing a smaller capacitive load $C_{L1}$ and $V_{L2}$ corresponding to a larger capacitive load $C_{L2}$. After time T, the load voltages do not change since the output of comparator 525 remains high, turning off the supplied current $I_L$.

The driver and the control circuits 510 and 530 essentially replicate their corresponding functions described in the first embodiment. The control circuit 530 (a voltage comparator) senses the load voltage $V_{L1}$ or $V_{L2}$ at an inverting comparator input and a reference voltage $V_{ref1}$ at a non-inverting port. In response, the comparator 530 supplies a control signal to the driver circuit 510, as described above. In the case where $V_{L1}$ is the sensed load voltage, the comparator 530 outputs a low signal to reduce the drive current, and visa versa for the case in which $V_{L2}$ is sensed. No latch circuit is needed since the charging duration is controlled in the charging circuit 520 by the control signal CTRL.

While the above description is complete with regards to the preferred embodiments of the invention, other variations, modifications and equivalents will be evident to those skilled in the art. For example, in the exemplary embodiments described the control circuits compare the output voltage $V_L$ to a single $V_{ref}$ level to decide between a large or small capacitive load. Other embodiments are possible wherein the control circuit includes multiple comparators comparing $V_L$ to multiple reference voltages. Comparison of $V_L$ to multiple reference levels increases the resolution of the circuit and allows for a further fine tuning of the drive capability of the adaptive driver circuit. Therefore, the above description is not intended to define the complete scope of the invention, which is appropriately defined by the following claims.

**Claims**

1. An adaptive drive circuit (300) having a variable drive output capacity, comprising:

   a driver circuit (310) having an input terminal (310a) configured to receive an input signal, an output terminal (310b) configured to transmit an output signal to a capacitive load, and a control terminal (310c) configured to receive a control signal, said control signal operating to vary the output drive of said driver circuit (310);
   a charging circuit (320) coupled to said output terminal (310b) configured to supply a reference current ($I_2$) thereto; and
   a control circuit (330) coupled to said output terminal (310b) and to said driver circuit (310) being configured to sense a capacitive load voltage ($V_L$) developed in response to said supplied reference current ($I_L$), said control circuit (330) generating a control signal in response to said sensed capacitive load voltage ($V_L$); wherein said reference current ($I_L$) is supplied to said output terminal (310b) for a time duration dependent on the magnitude of said reference current ($I_L$).

2. The adaptive driver circuit (300) of claim 1, wherein said control circuit (330) comprises a first voltage comparator (334) having a first input terminal coupled to said output terminal (310b), a second input terminal coupled to a first reference voltage source (332), and a first comparator output terminal.

3. The adaptive driver circuit (300) of claim 2, wherein said control circuit (330) further comprises a latch circuit (336) having an input terminal coupled to said comparator output terminal, a latch output terminal, and a strobe input terminal (STRB) configured to receive a signal to activate said latch circuit (336).

4. The adaptive driver circuit (300) of claim 3, wherein said charging circuit (320) comprises:

   a current source (322) configured to produce a predefined current ($I_B$); and
   a current mirror (324) coupled to said current source (322) configured to produce said reference current ($I_L$) in response to said predefined current ($I_B$).

5. The adaptive drive circuit (300) of claim 4, wherein said charging circuit (320) further comprises an enabling transistor (326) coupled to said current mirror (324) for controlling said reference current ($I_L$).

6. The adaptive driver circuit (300) of claim 2, wherein said charging circuit (52) comprises:

   a current source (322) configured to produce a predefined current ($I_B$);
   a current mirror (522) coupled to said current source (322) configured to produce an internal current ($I_{INT}$) in response to said predefined current ($I_B$);
   an internal capacitor (523) coupled to said current mirror (522) configured to receive said internal current ($I_{INT}$), said capacitor (523) developing an internal voltage $V_{INT}$) thereacross in response to said received internal current ($I_{INT}$);
   a second voltage comparator (525) having a first input coupled to said internal capacitor (523), a second input coupled to a second reference voltage source (524) and an output terminal configured to produce a switch signal (CNTRL);
   a switch transistor having an input configured to receive said switch signal (CNTRL) and an output coupled to said unknown capacitive load (54) configured to supply said reference current ($I_L$) thereto in response to said switch signal (CNTRL).

7. The adaptive driver circuit (300) of claim 6, wherein said first comparator output terminal is coupled to said control terminal (510c) of said driver circuit (510).

8. In an adaptive driver circuit (300) having a driver circuit (310) configured to receive and output signals, a charging circuit (320) configured to supply a reference current ($I_L$), and a control circuit (330) for controlling the output drive of the driver circuit (310), a method for varying the output drive delivered to an unknown capacitive load ($C_L$), the method comprising the steps of:

   charging said unknown capacitive load ($C_L$) with a reference current ($I_L$) for a time duration dependent on the magnitude of said reference current;
   developing a load voltage ($V_L$) across said unknown capacitive load ($C_L$) in response to said supplied reference current ($I_L$);

comparing said load voltage ($V_L$) with a first reference voltage ($V_{ref}$);

producing a control signal corresponding to said comparison between said load voltage ($V_L$) and said first reference voltage ($V_{ref}$); and

providing said control signal to said driver circuit (310), wherein said output drive of said driver circuit (310) varies in relation to said driver control signal.

**9.** The method of claim 8, wherein said step of charging said unknown capacitive load ($C_L$) comprises the steps of:

supplying a predefined current ($I_B$) to a current mirror (324); and

in response, supplying said reference current ($I_L$) from said current mirror (324) to said unknown capacitive load ($C_L$).

**10.** The method of claim 9, wherein said step of producing a control signal comprises the steps of:

sampling, after a predefined duration, said comparison between said first reference voltage ($V_{ref}$) and said load voltage ($V_L$); and

outputting said control signal in response to said sampling step.

**11.** The method of claim 8, wherein said step of producing a reference current ($I_L$) comprises the steps of:

supplying a predefined current ($I_B$) to a current mirror (522);

in response, outputting an internal current ($I_{INT}$) from said current mirror (522); supplying said internal current ($I_{INT}$) to an internal capacitance (523);

in response, developing an internal voltage ($V_{INT}$) across said internal capacitance (523);

comparing said internal voltage ($V_{INT}$) to a second reference voltage ($V_{ref2}$);

in response, outputting a switch signal (CNTRL);

supplying said switch signal (CNTRL) to a switch transistor (S1);

in response, supplying said reference current ($I_V$) from said current mirror (522) to said unknown capacitive load ($C_L$)

## Patentansprüche

**1.** Adaptive Treiberschaltung (300) mit einer variablen Treiber-Ausgangskapazität, enthaltend:

eine Treiberschaltung (310) mit einem Eingangsanschluss (310a), der zum Erhalt eines Eingangssignals konfiguriert ist, einem Ausgangsanschluss (310b), der zum Übertragen eines Ausgangssignals an eine kapazitive Last konfiguriert ist, und einem Steueranschluss (310c), der zum Erhalt eines Steuersignals konfiguriert ist, wobei das Steuersignal eine Veränderung der Ausgangs-Treiberleistung der Treiberschaltung (310) bewirkt; eine mit dem Ausgangsanschluss (310b) verbundene Ladeschaltung (320), die zum Anlegen eines Referenzstroms ($I_2$) an diesen konfiguriert ist; sowie

eine mit dem Ausgangsanschluss (310b) und der Treiberschaltung (310) verbundene Steuerschaltung (330), die zum Fühlen einer kapazitiven Lastspannung ($V_L$) konfiguriert ist, welche in Abhängigkeit von dem anliegenden Referenzstrom ($I_L$) erzeugt wird, wobei die Steuerschaltung (330) in Abhängigkeit von der erfühlten kapazitiven Lastspannung ($V_L$) ein Steuersignal erzeugt; wobei der Referenzstrom ($I_L$) über einen Zeitraum an dem Ausgangsanschluss (310b) angelegt wird, welcher von der Höhe des Referenzstroms ($I_L$) abhängt.

**2.** Adaptive Treiberschaltung (300) nach Anspruch 1, wobei die Steuerschaltung (330) einen ersten Spannungskomparator (334) mit einem mit dem Ausgangsanschluss (310b) verbundenen Eingangsanschluss, einen mit einer ersten Referenz-Spannungsquelle (332) verbundenen zweiten Eingangsanschluss sowie einen ersten Komparator-Ausgangsanschluss umfasst.

**3.** Adaptive Treiberschaltung (300) nach Anspruch 2, wobei die Steuerschaltung (330) weiterhin eine Latch-Schaltung (336) mit einem mit dem Komparator-Ausgangsanschluss verbundenen Eingangsanschluss, einem Latch-Ausgangsanschluss und einem Abtastimpuls-(Strobe)-Eingangsanschluss (STRB) umfasst, der zum Empfangen eines Signals zum Aktivieren der Latch-Schaltung (336) konfiguriert ist.

**4.** Adaptive Treiberschaltung (300) nach Anspruch 3, wobei die Ladeschaltung (320) folgendes umfasst:

eine Stromquelle (322), die zum Erzeugen eines vorbestimmten Stroms ($I_B$) konfiguriert ist; sowie
einen mit der Stromquelle (322) verbundenen Stromspiegel (324), der zum Erzeugen des Referenzstroms ($I_L$) in Abhängigkeit von dem vorbestimmten Strom ($I_B$) konfiguriert ist.

**5.** Adaptive Treiberschaltung (300) nach Anspruch 4, wobei die Ladeschaltung (320) weiterhin einen mit dem Stromspiegel (324) verbundenen Freischalt-Transistor (326) zum Steuern des Referenzstroms ($I_L$) umfasst.

**6.** Adaptive Treiberschaltung (300) nach Anspruch 2, wobei die Ladeschaltung (52) folgendes umfasst:

eine Stromquelle (322), die zum Erzeugen eines vorbestimmten Stroms ($I_B$) konfiguriert ist;
einen mit der Stromquelle (322) verbundenen Stromspiegel (522), der zum Erzeugen eines internen Stroms ($I_{INT}$) in Abhängigkeit von dem vorbestimmten Strom ($I_B$) konfiguriert ist;
einen mit dem Stromspiegel (522) verbundenen internen Kondensator (523), der zum Empfangen des internen Stroms ($I_{INT}$) konfiguriert ist, wobei der Kondensator (523) als Antwort auf den empfangenen internen Strom ($I_{INT}$) über dem Kondensator eine interne Spaltung ($V_{INT}$) entwickelt;
einen zweiten Spannungskomparator (525) mit einem mit dem internen Kondensator (523) verbundenen ersten Eingang, einem mit einer zweiten Referenz-Spannungsquelle (524) verbundenen zweiten Eingang und einem Ausgangsanschluss, das zum Erzeugen eines Schaltsignals (CNTRL) konfiguriert ist;
einen Schalt-Transistor mit einem Eingang, der zum Empfangen des Schaltsignals (CNTRL) konfiguriert ist, und einem mit der unbekannten kapazitiven Last (54) verbundenen Ausgang, der so konfiguriert ist, dass er als Antwort auf das Schaltsignal (CNTRL) an diese Last den Referenzstrom ($I_L$) abgibt.

**7.** Adaptive Treiberschaltung (300) nach Anspruch 6, wobei der erste Komparator-Ausgangsanschluss mit dem Steueranschluss (510c) der Treiberschaltung (510) verbunden ist.

**8.** Bei einer adaptiven Treiberschaltung (300) mit einer zum Empfangen und Abgeben von Signalen konfigurierten Treiberschaltung (310), einer zum Abgeben eines Referenzstroms ($I_L$) konfigurierten Ladeschaltung (320) und einer Steuerschaltung (330) zum Steuern der Ausgangs-Treiberleistung der Treiberschaltung (310), Verfahren zum Variieren der an eine unbekannte kapazitive Last ($C_L$) abgegebenen Ausgangs-Treiberleistung, wobei das Verfahren folgende Schritte umfasst:

Laden der unbekannten kapazitiven Last ($C_L$) mit einem Referenzstrom ($I_L$) für einen Zeitraum, der von der Höhe des Referenzstroms abhängt;
Entwickeln einer Lastspannung ($V_L$) über der unbekannten kapazitiven Last ($C_L$) in Abhängigkeit von dem gelieferten Referenzstrom ($I_L$);
Vergleichen der Lastspannung ($V_L$) mit einer ersten Referenzspannung ($V_{ref}$);
Erzeugen eines Steuersignals entsprechend dem Vergleich zwischen der Lastspannung ($V_L$) und der ersten Referenzspannung ($V_{ref}$); sowie
Anlegen des Steuersignals an die Treiberschaltung (310), wobei die Ausgangs-Treiberleistung der Treiberschaltung (310) in Relation zu dem Treiber-Steuersignal variiert.

**9.** Verfahren nach Anspruch 8, wobei der Schritt des Ladens der unbekannten kapazitiven Last ($C_L$) folgende Schritte umfasst:

Anlegen eines vorbestimmten Stroms ($I_B$) an einen Stromspiegel (324); sowie
als Antwort, Anlegen des Referenzstroms ($I_L$) von dem Stromspiegel (324) an die unbekannte kapazitive Last ($C_L$).

**10.** Verfahren nach Anspruch 9, wobei der Schritt des Erzeugens eines Steuersignals folgende Schritte umfasst:

Abfragen, nach einer vorbestimmten Zeitspanne, des Vergleichs zwischen der ersten Referenzspannung ($V_{ref}$) und der Lastspannung ($V_L$); sowie
Ausgeben des Steuersignals als Antwort auf den Abfrageschritt.

**11.** Verfahren nach Anspruch 8, wobei der Schritt des Erzeugens eines Referenzstroms ($I_L$) folgende Schritte umfasst:

Anlegen eines vorbestimmten Stroms ($I_B$) an den Stromspiegel (522);

as Antwort, Abgeben eines internen Stroms ($I_{INT}$) von dem Stromspiegel (522);

Anlegen des internen Stroms ($I_{INT}$) an eine interne Kapazität (523); as Antwort, Entwickeln einer internen Spannung ($V_{INT}$) über der internen Kapazität (523);

Vergleichen der internen Spannung ($V_{INT}$) mit einer zweiten Referenzspannung ($V_{ref2}$);

als Antwort, Ausgeben eines Schaltsignals (CNTRL);

Anlegen des Schaltsignals (CNTRL) an einen Schalt-Transistor (S1);

als Antwort, Anlegen des Referenzstroms ($I_V$) von dem Stromspiegel (522) an die unbekannte kapazitive Last ($C_L$).

**Revendications**

1.  Circuit adaptatif de pilotage (300) possédant une capacité de sortie de pilotage variable, comprenant :

    un pilote (310) possédant un terminal d'entrée (310a) configuré pour recevoir un signal d'entrée, un terminal de sortie (310b) configuré pour transmettre un signal de sortie à une charge capacitive, et un terminal de commande (310c) configuré pour recevoir un signal de commande, ledit signal de commande fonctionnant pour faire varier la sortie de pilotage dudit pilote (310) ;
    un circuit de charge (320) couplé audit terminal de sortie (310b) configuré pour fournir un courant de référence ($I_L$) à celui-ci ; et
    un circuit de commande (330) couplé audit terminal de sortie (310b) et audit pilote (310) étant configuré pour détecter une tension de charge capacitive ($V_L$) développée en réponse audit courant de référence délivré ($I_L$), ledit circuit de commande (330) générant un signal de commande en réponse à ladite tension de charge capacitive détectée ($V_L$) ;

    dans lequel ledit courant de référence ($I_L$) est fourni audit terminal de sortie (310b) pour une durée dépendant de l'amplitude dudit courant de référence ($I_L$).

2.  Circuit adaptatif de pilotage (300) selon la revendication 1, dans lequel ledit circuit de commande (330) comprend un premier comparateur de tension (334) possédant un premier terminal d'entrée couplé audit terminal de sortie (310b), un second terminal d'entrée couplé à une première source de tension de référence (332), et un premier terminal de sortie de comparateur.

3.  Circuit adaptatif de pilotage (300) selon la revendication 2, dans lequel ledit circuit de commande (330) comprend en outre un circuit de verrouillage (336) possédant un terminal d'entrée couplé audit terminal de sortie de comparateur, un terminal de sortie de bascule, et un terminal d'entrée d'échantillonnage (STRB) configuré pour recevoir un signal afin d'activer ledit circuit de verrouillage (336).

4.  Circuit adaptatif de pilotage (300) selon la revendication 3, dans lequel ledit circuit de charge (320) comprend :

    une source de courant (322) configurée pour produire un courant prédéfini ($I_B$) ; et
    un miroir de courant (324) couplé à ladite source de courant (322) configuré pour produire ledit courant de référence ($I_L$) en réponse audit courant prédéfini ($I_B$).

5.  Circuit adaptatif de pilotage (300) selon la revendication 4, dans lequel ledit circuit de charge (320) comprend en outre un transistor d'activation (326) couplé audit miroir de courant (324) pour commander ledit courant de référence ($I_L$).

6.  Circuit adaptatif de pilotage (300) selon la revendication 2, dans lequel ledit circuit de charge (52) comprend :

    une source de courant (322) configurée pour produire un courant prédéfini ($I_B$) ;
    un miroir de courant (522) couplé à ladite source de courant (322) configuré pour produire un courant interne ($I_{INT}$) en réponse au dit courant prédéfini ($I_B$) ;
    une capacité interne (523) couplée audit miroir de courant (522) configuré pour recevoir ledit courant interne ($I_{INT}$), ladite capacité (523) développant une tension interne ($V_{INT}$) au travers de celle-ci en réponse audit courant interne reçu ($I_{INT}$) ;
    un second comparateur de tension (525) possédant une première entrée couplée à ladite capacité interne (523), une seconde entrée couplée à une seconde source de tension de référence (524) et un terminal de sortie configuré pour produire un signal de commutation (CNTRL) ;

un transistor de commutation possédant une entrée configurée pour recevoir ledit signal de commutation (CNTRL) et une sortie couplée à ladite charge capacitive inconnue (54) configurée pour fournir ledit courant de référence ($I_L$) à celle-ci en réponse audit signal de commutation (CNTRL).

7. Circuit adaptatif de pilotage (300) selon la revendication 6, dans lequel ledit premier terminal de sortie de comparateur est couplé audit terminal de commande (510c) dudit pilote (510).

8. Dans un circuit adaptatif de pilotage (300) comprenant un pilote (310) configuré pour recevoir et délivrer des signaux, un circuit de charge (320) configuré pour délivrer un courant de référence ($I_L$), et un circuit de commande (330) pour commander la sortie de pilotage du pilote (310), un procédé pour faire varier la sortie de pilotage délivrée à une charge capacitive inconnue ($C_L$), le procédé comprenant les étapes consistant à :

charger ladite charge capacitive inconnue ($C_L$) avec un courant de référence ($I_L$) pour une durée dépendant de l'amplitude dudit courant de référence ;

développer une tension de charge ($V_L$) au travers de ladite charge capacitive inconnue ($C_L$) en réponse audit courant de référence délivré ($I_L$) ;

comparer ladite tension de charge ($V_L$) à une première tension de référence ($V_{ref}$) ;

produire un signal de commande correspondant à ladite comparaison entre ladite tension de charge ($V_L$) et ladite première tension de référence ($V_{ref}$) ; et

fournir ledit signal de commande audit pilote (310), dans lequel ladite sortie de pilotage dudit pilote (310) varie en fonction dudit signal de commande de pilote.

9. Procédé selon la revendication 8, dans lequel ladite étape de charge de ladite charge capacitive inconnue ($C_L$) comprend les étapes consistant à :

fournir un courant prédéfini ($I_B$) à un miroir de courant (324) ; et

en réponse, fournir ledit courant de référence ($I_L$) issu dudit miroir de courant (324) à ladite charge capacitive inconnue ($C_L$).

10. Procédé selon la revendication 9, dans lequel ladite étape de production d'un signal de commande comprend les étapes consistant à :

échantillonner, après une durée prédéfinie, ladite comparaison entre ladite première tension de référence ($V_{ref}$) et ladite tension de charge ($V_L$) ; et

délivrer ledit signal de commande en réponse à ladite étape d'échantillonnage.

11. Procédé selon la revendication 8, dans lequel ladite étape de production d'un courant de référence ($I_L$) comprend les étapes consistant à :

fournir un courant prédéfini ($I_B$) à un miroir de courant (522) ;

en réponse, délivrer un courant interne ($I_{INT}$) issu dudit miroir de courant (522) ;

fournir ledit courant interne ($I_{INT}$) à une capacité interne (523) ;

en réponse, développer une tension interne ($V_{INT}$) au travers de ladite capacité interne (523) ;

comparer ladite tension interne ($V_{INT}$) à une seconde tension de référence ($V_{ref2}$) ;

en réponse, délivrer un signal de commutation (CNTRL) ;

fournir ledit signal de commutation (CNTRL) à un transistor de commutation (S1) ;

en réponse, fournir ledit courant de référence ($I_V$) issu dudit miroir de courant (522) à ladite charge capacitive inconnue ($C_L$).

FIG. 1

FIG. 2

FIG. 3

FIG. 4A

FIG. 4B

FIG. 4C

FIG. 4D

FIG. 4

EP 1 097 386 B1

FIG. 5

FIG. 6